# EUROPEAN PATENT SPECIFICATION

(11) **EP 0 827 152 B1**
(45) Date of publication and mention of the grant of the patent: **26.03.2003**
(21) Application number: 96114022.5
(22) Date of filing: 02.09.1996
(51) Int. Cl.: G11C 7/06

(54) **Current-mode sense amplifier**
Leseverstärker in Strombetriebsart
Amplificateur de lecture en mode de courant

(43) Date of publication of application: 04.03.1998
(73) Proprietor: Infineon Technologies AG, 81669 München (DE)
(72) Inventor: Meindl, Xaver, 83043 Bad Aibling (DE); Cheung, Chu-Ming, Singapore 520438 (SG)
(74) Representative: Epping Hermann & Fischer

(56) References cited:
- EP-A- 0 420 189
- DE-A- 4 326 133
- US-A- 5 056 063
- US-A- 5 258 669
- US-A- 5 341 333
- IEEE JOURNAL OF SOLID-STATE CIRCUITS, vol. 26, no. 4, 1 April 1991, pages 542-548, XP000216725 BLALOCK T N ET AL: "A HIGH-SPEED CLAMPED BIT-LINE CURRENT-MODE SENSE AMPLIFIER"
- IEEE JOURNAL OF SOLID-STATE CIRCUITS, vol. 26, no. 4, 1 April 1991, pages 525-535, XP000216723 SEEVINCK E ET AL: "CURRENT-MODE TECHNIQUES FOR HIGH-SPEED VLSI CIRCUITS WITH APPLICATION TO CURRENT SENSE AMPLIFIER FOR CMOS SRAM'S"

## Description

The invention relates to a current amplifier and particularly to a current-mode sense amplifier for sensing the bitline of a memory.

In semiconductor memories the information stored in a memory cell has to be sensed and amplified for reading. A number of memory cells is connected to a bitline whereby a particular cell is selected for reading through a wordline. A sense amplifier connected to the bitline detects and amplifies the information stored in the selected memory cell.

In the article "Travis N. Blalock et al.: "A High-Speed Clamped Bit-Line Current-Mode Sense Amplifier", IEEE Journal of Solid State Circuits, Vol. 26, No. 4, April 1991, Pages 13 to 19 a current-mode sense amplifier for a CMOS memory cell is described. The known current-mode sense amplifier compares the input current from a memory cell with a reference current. The reference current is provided by a dummy memory cell producing a current that is between the currents representing the digital logic states. Usually, the reference level is designed at the mid-point between no data current and minimum data current. The current-mode sense amplifier detects a data input current above or below the reference current as the different digital logic states.

The known sense amplifier demands a high degree of layout symmetry between the sense amplifier transistor pairs, especially with respect to element orientation or dimensioning. The transistor count is rather high and needs much chip area. Its operation is very susceptible to cross talk effects. The layout design of the amplifier itself and of the memory cell array must consider the crosstalk risk. The sense amplifier layout must be compact to avoid significant contribution on internal node capacitances by transistor interconnections. The sense amplifier is highly sensitive leading to the disadvantage that it is susceptible to noise and process variations due to the sensitive nodes of the amplifier and its high gain feedback loop. This may affect the current margin of the sense amplifier.

Document US 5,258,669 discloses a sense amplifier comprising all the features of the preamble of claim 1.

It is an object of the invention, to provide a current-mode amplifier that works more stable than prior art amplifiers. Further, the expense for the realization of the circuit shall be decreased.

The above mentioned object is solved by a current-mode amplifier according to the features of claim 1.

The current-mode amplifier according to the invention comprises a controlled current mirror design with a precharge capacitor. No reference current is required. The transistor count is relatively low. The design layout of the amplifier requires no symmetry. The amplifier has no high gain feedback loop or any sensitive node. Hence, it is less susceptible to noise or manufacture process variations. The current-mode sense amplifier according to the invention determines a logic state based on its input current information. The input data is either the state of a current flow or the state of no current flow representing a digital logic value.

The invention and its advantages are described more in detail in the accompanying drawings showing two preferred embodiments, wherein
- figure 1: shows a first embodiment of the invention and
- figure 2: shows a second embodiment of the invention.

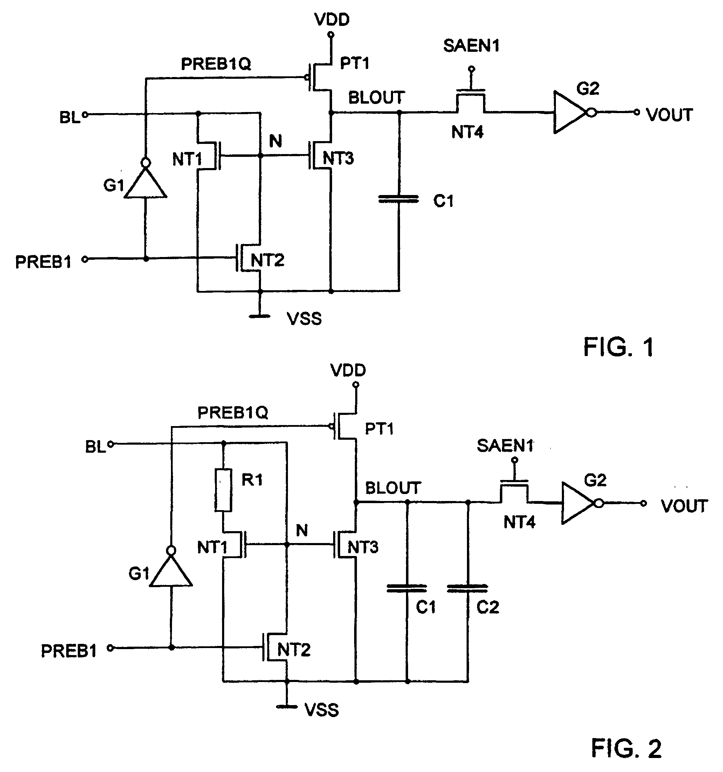

The current-mode sense amplifier of figure 1 comprises four n-channel-enhancement-type-transistors (NMOS), one p-channel-MOS-transistor, and an inverter comprising two complementary MOS-transistors. The bulk voltage of the PMOS-transistor is connected to the positive power supply VDD, the bulk voltage for the NMOS-transistors is connected to a negative supply voltage (e.g. -2.0 Volt) or is connected to ground potential VSS depending on technology. The amplifier comprises a current mirror circuit comprising current mirror transistors NT1, NT3. The gates from transistors NT1, NT3 are connected with each other forming node N. The drain and gate electrodes from transistor NT1 are connected together. The source electrodes from transistors NT1, NT3 are connected to the terminal for ground potential VSS. Transistor NT1 forms the input branch of the current mirror circuit, transistor NT3 forms its output branch. The drain of transistor NT3 is connected to a terminal for the positive supply potential VDD through a PMOS-transistor PT1. The node between transistors NT3 and PT1 is connected to one electrode of a capacitor C1 carrying signal BLOUT, the second electrode of which is connected to the ground terminal. The gates of current mirror transistors NT1, NT3 are connected to ground terminal through the drain source path of a NMOS-transistor NT2. The gates of transistors NT2, PT1 are controlled by precharge control signal PREB1. NMOS-transistor NT2 is directly controlled by signal PREB1, PMOS-transistor PT1 is controlled by the inverted signal PREB1Q. Signal PREB1Q is generated from signal PREB1 through an inverter G1. The input branch of the current mirror circuit is connected to an input terminal for inputting a signal BL to be current sensed. Thus, the connection node between drain and gate electrodes from transistor NT1 is connected to the bitline of the memory array. The first terminal of capacitor C1 being connected to the node between transistors PT1, NT3 is connected through a gating device to another amplifier circuit forming the output signal of the current-mode sense amplifier. The gating device is a pass transistor NT4, being controlled by a read signal SAEN1. Said other amplifier circuit providing pulse shaping is an CMOS-inverter G2. The output signal VOUT at the output of inverter G2 provides the sensed and amplified input signal BL.

The basic operation of the sense amplifier in figure 1 is as follows. When precharge signal PREB1 is active during the precharge phase, capacitor C1 is being charged. After the precharge phase signal PREBQ1 is inactive and bitline signal BL is provided from a memory cell. In the first state bitline signal BL is a current into the amplifier representing the logic state "0" and in the second state is no current representing the logic state "1". Depending on the signal BL capacitor C1 is discharged or maintains its charge. Then, read out enable signal SAEN1 is activated for providing the charge state of capacitor C1 to pulse forming inverter G2 the output of which provides output signal VOUT.

In detail, the amplifier shown in figure 1 operates as follows. During precharge phase the control signal PREB1 is "1" and control signal SAEN1 is "0". Control transistor NT2 is turned on connecting the gates of transistors NT1, NT3 (node N) to ground potential VSS and thereby setting node N to logic "0". Signal PREB1Q is "0" turning on transistor PT1. Hence, current flows from the supply terminal for the positive supply potential VDD into capacitor C1 charging capacitor C1. Transistors NT1, NT3 are turned off since node N is logic "0". When capacitor C1 is charged, the signal BLOUT is at potential VDD which is logic "1".

Sensing and discharging phase is as follows. After capacitor C1 is fully charged, precharge signal PREB1 goes from "1" to "0". Node N is isolated from ground potential VSS and becomes floating. Control transistors PT1, NT2 are turned off. The current information from input signal BL at node N is then sensed by the current mirror circuit. Different logic states are reflected by monitoring, whether there is any drop of voltage level of signal BLOUT from potential VDD to potential VSS or not.

With memory data being logic "0" input signal BL inputs a current from the memory cell. This induces the node N which rises its voltage level from potential VSS to the threshold voltage of transistor NT3. Once, the threshold voltage is reached, both transistors NT1 and NT3 are turned on, the current mirror circuit beginning to conduct current. The current from the memory cell flowing through the input branch of the current mirror circuit through transistor NT1 is mirrcred into the output branch flowing through transistor NT3. Since transistor PT1 is turned off, the current through transistor NT3 is actually provided from capacitor C1. Capacitor C1 is discharged and signal BLOUT falls from potential VDD to potential VSS, from logic "1" to logic "0".

With memory data being logic "1" there is no current flowing out of the memory cell. The node N remains floating. Transistors NT1, NT3 remain turned off and the current mirror branches conduct no current. There is no current path, e.g. through transistor NT3, that would discharge capacitor C1. Thus, signal BLOUT maintains at potential VDD which is logic "1".

The operation during the latching phase is as follows. After sensing and discharging, the logical state of signal BLOUT is stable at logic "0" or logic "1". The read signal SAEN1 is activated and goes from logic "0" to logic "1". Pass transistor NT4 is turned on and the signal BLOUT is passed to inverter G2. Inverter G2 inverts the logic state of signal BLOUT and outputs signal VOUT.

In the other preferred embodiment of figure 3 there are two split capacitors C1, C2. One of the capacitors may be switched off or deactivated when the circuit design has propagation time constraints. With one of the capacitors switched off the sense amplifier is working faster as the RC-time constant is smaller. Switching off is usually performed during the testing process after manufacture. Further, there is an ohmic resistor R1 connected between the bitline input and the drain of transistor NT1. Through adjusting the resistance of ohmic resistor R1 the discharge time of capacitors C1, C2 is controllable.

The current-mode sense amplifier according to the invention is preferably applicable for current sensing the bitline signal provided during reading from memory cells. The amplifier is preferably applicable for read only n.emories (ROM). As the amplifier has a low transistor count and covers a small chip area, does not require any layout symmetry considerations, and is less susceptible to signal noise, it is especially suitable for embedded ROMs that are part of a larger chip containing further logic and analog circuitry. However, the amplifier may also be used in other fields where current sensing has to be performed, e.g. in analog-digital conversions circuits or comparator circuits.

## Claims

1. Current amplifier comprising: a current mirror circuit having an input branch (NT1, R1) and an output branch (NT3), said input branch (NT1, R1) being connected at one end to a terminal for an input signal (BL) to be current amplified and being connected at another end to a first supply terminal (VSS), said output branch (NT3) being connected at one end through a first control transistor (PT1) to a second supply terminal (VDD) and to a capacitive device (C1, C2) and being connected at another end to said first supply terminal (VSS), **characterised in that** a second control transistor (NT2) is connected from a connection node (N) between said current mirror branches (NT1, R1; NT3) to said first supply terminal (VSS), said control transistors (PT1, NT2) being controlled by a control signal (PREB1, PREB1Q) for precharching the capacitive device (C1, C2) prior to the application of said input signal (BL).

2. Current amplifier according to claim 1,
wherein said control signal (PREB1, PREB1Q) for precharching the capacitive device (C1, C2) is applied in inverted relationship to the first control transistor (PT1) with respect to the second control transistor (NT2).

3. Current amplifier according to claim 1 or 2,
wherein said capacitive device (C1, C2) is connected between said one end of said second branch (NT3) of said current mirror circuit and said first supply terminal (VSS).

4. Current amplifier according to claim 3,
wherein said one end of said second branch (NT3) of said current mirror circuit is connected through a gating device (NT4) to another amplifier device (G2).

5. Current amplifier according to claim 4,
wherein said gating device is a path transistor (NT4) and said another amplifier device being an inverter (G2).

6. Current amplifier according to any of the preceding claims,
wherein said first branch (NT1, R1) of said current mirror circuit comprises the drain source path of a transistor (NT1) and an ohmic resistor (R1) connected between said drain source path of said transistor (NT1) and said one end of said first branch of said current mirror circuit.

## Patentansprüche

1. Stromverstärker, umfassend: eine Stromspiegelschaltung mit einem Eingangszweig (NT1, R1) und einem Ausgangszweig (NT3), wobei der Eingangszweig (NT1, R1) an einem Ende mit einem Anschluß für ein Eingangssignal (BL) verbunden ist, das stromverstärkt werden soll, und am anderen Ende mit einem ersten Versorgungsanschluß (VSS), wobei der Ausgangszweig (NT3) an einem Ende durch einen ersten Steuertransistor (PT1) mit einem zweiten Versorgungsanschluß (VDD) und mit einem kapazitiven Bauelement (C1, C2) und an einem anderen Ende mit dem ersten Versorgungsanschluß (VSS) verbunden ist, **dadurch gekennzeichnet, daß** ein zweiter Steuertransistor (NT2) von einem Verbindungsknoten (N) zwischen den Zweigen des Stromspiegels (NT1, R1; NT3) zu dem ersten Versorgungsanschluß (VSS) geschaltet ist, wobei die Steuertransistoren (PT1, NT2) durch ein Steuersignal (PREB1, PREB1Q) zum Vorladen des kapazitiven Bauelements (C1, C2) vor dem Anlegen des Eingangssignals (BL) gesteuert werden.

2. Stromverstärker nach Anspruch 1, wobei das Steuersignal (PREB1, PREB1Q) zum Vorladen des kapazitiven Bauelements (C1, C2) in mit Bezug auf den zweiten Steuertransistor (NT2) invertierter Beziehung an den ersten Steuertransistor (PT1) angelegt wird.

3. Stromverstärker nach Anspruch 1 oder 2, wobei das kapazitive Bauelement (C1, C2) zwischen das eine Ende des zweiten Zweiges (NT3) der Stromspiegelschaltung und den ersten Versorgungsanschluß (VSS) geschaltet ist.

4. Stromverstärker nach Anspruch 3, wobei das eine Ende des zweiten Zweiges (NT3) der Stromspiegelschaltung durch ein Torschaltungsbauelement (NT4) mit einem anderen Verstärkerbauelement (G2) verbunden ist.

5. Stromverstärker nach Anspruch 4, wobei das Torschaltungsbauelement ein Transistor (NT4) und das andere Verstärkerbauelement ein Inverter (G2) ist.

6. Stromverstärker nach einem der vorhergehenden Ansprüche, wobei der erste Zweig (NT1, R1) der Stromspiegelschaltung den Drain-Source-Pfad eines Transistors (NT1) und einen zwischen Drain-Source-Pfad des Transistors (NT1) und das eine Ende des ersten Zweiges der Stromspiegelschaltung geschalteten Ohmschen Widerstand (R1) umfaßt.

## Revendications

1. Amplificateur de courant comprenant : un circuit formant miroir de courant ayant une branche d'entrée (NT1, R1) et une branche de sortie (NT3), ladite branche d'entrée (NT1, R1) étant connectée par une extrémité à une borne destinée à un signal d'entrée (BL) devant être amplifié en courant et étant connectée par une autre extrémité à une première borne d'alimentation (VSS), la branche de sortie (NT3) étant connectée par une extrémité à travers un premier transistor de commande (PT1) à une deuxième borne d'alimentation (VDD) et à un dispositif capacitif (C1, C2) et étant connectée par une autre extrémité à la première borne d'alimentation (VSS), **caractérisé en ce qu'**un deuxième transistor de commande (NT2) est connecté d'un noeud de connexion (N) situé entre les branches formant miroir de courant (NT1, R1 ; NT3) à la première borne d'alimentation (VSS), les transistors de commande (PT1, NT2) étant commandés par un signal de commande (PREB1, PREB1Q) destinés à précharger le dispositif capacitif (C1, C2) avant l'application du signal d'entrée (BL).

2. Amplificateur de courant suivant la revendication 1, dans lequel le signal de commande (PREB1, PREB1Q) destiné à précharger le dispositif capacitif (C1, C2) est appliqué selon une relation inversée au premier transistor de commande (PT1) par rapport au deuxième transistor de commande (NT2).

3. Amplificateur de courant suivant la revendication 1 ou 2, dans lequel le dispositif capacitif (C1, C2) est connecté entre l'extrémité en question de la deuxième branche (NT3) du circuit formant miroir de courant et la première borne d'alimentation (VSS).

4. Amplificateur de courant suivant la revendication 3, dans lequel l'extrémité en question de la deuxième branche (NT3) du circuit formant miroir de courant est connectée à travers un dispositif à porte (NT4) à un autre dispositif amplificateur (G2).

5. Amplificateur de courant suivant la revendication 4, dans lequel le dispositif à porte est un transistor de trajet (NT4) et l'autre dispositif amplificateur est un inverseur (G2).

6. Amplificateur de courant suivant l'une quelconque des revendications précédentes, dans lequel la première branche (NT1, R1) du circuit formant miroir de courant comprend le trajet drain-source d'un transistor (NT1) et une résistance ohmique (R1) connectée entre le trajet drain-source du transistor NT1 et l'extrémité en question de la première branche du circuit formant miroir de courant.
